# DEMANDE DE BREVET EUROPEEN

(11) **EP 2 105 755 A1**
(43) Date de publication de la demande: **30.09.2009**
(21) Numéro de dépôt: 09003661.7
(22) Date de dépôt: 13.03.2009
(51) Int. Cl.: G01R 31/36

(54) **Procédé d'estimation de la charge d'une batterie d'un véhicule automobile**

(30) Priorité: 27.03.2008 FR 0801664
(71) Demandeur: Continental Automotive France, 31100 Toulouse (FR)
(72) Inventeur: Sans, Mariano, 31700 Blagnac (FR); Baffaut, Pierre-Antoine, 31500 Toulouse (FR); Boucharel, Paul, 31000 Toulouse (FR)

(57) **Abrégé**

Procédé d'estimation de la charge d'une batterie d'un véhicule automobile dans lequel au moins un capteur fournit la tension aux bornes de la batterie, le courant circulant dans la batterie et la température de celle-ci, tel:
• que des variations de courant sont mesurées à des intervalles de temps prédéterminés,
• qu'une tension modélisée est déterminée en fonction du courant et de la température,
• que la tension modélisée comporte une composante correspondant à la charge et une composante correspondant à la polarisation de la batterie,
• que la tension estimée est comparée à la tension mesurée afin de déterminer une erreur de tension,
• qu'une adaptation du modèle théorique est réalisée en fonction de la phase de fonctionnement de la batterie et en fonction de l'erreur de tension déterminée, et

le procédé étant **caractérisé en ce qu**'aux phases de fonctionnement de la batterie en charge et en décharge correspondent à chaque fois des sous-états de fonctionnement comportant le fonctionnement saturé à 100%, le fonctionnement saturé à près de 100%, le fonctionnement normal, le fonctionnement chargé à près de 0% et le fonctionnement chargé à 0% et en ce que pour ces divers sous états, l'adaptation est réalisée pour le calcul théorique de l'état de charge de la batterie et/ou pour le calcul de la composante correspondant à la polarisation de la batterie, l'estimation de l'état de charge de la batterie étant déterminée à l'aide du modèle théorique adapté.

## Description

La présente invention concerne un procédé d'estimation de la charge d'une batterie d'un véhicule automobile.

Pour déterminer l'état d'une batterie dans un véhicule automobile, deux types de paramètres sont usuellement utilisés. On utilise tout d'abord l'état de charge qui indique, en pourcentage, la charge de la batterie par rapport à sa charge maximale. Cet état de charge doit pouvoir être déterminé quel que soit le type de batterie utilisé dans le véhicule automobile. On utilise également l'état de santé de la batterie qui est fonction de divers paramètres internes de la batterie comme notamment la résistance interne de la batterie, la capacité maximum de charge de cette batterie et l'acceptance de charge qui correspond à la tension au-delà de laquelle la charge de la batterie n'est plus efficace.

La présente invention concerne plus particulièrement l'état de charge d'une batterie. Cet état de charge est défini selon les conditions normales d'utilisation prédéfinies qui correspondent à des normes pouvant varier d'un pays à l'autre.

Pour déterminer l'état de charge d'une batterie, on peut mesurer la tension à vide (circuit ouvert) aux bornes de la batterie en réalisant une mesure de haute précision afin de déterminer la densité de l'acide présent dans la batterie. Cette méthode de mesure n'est réalisable qu'après une longue période de repos de la batterie. À de basses températures, le temps nécessaire de repos après une phase de charge peut être très long, par exemple de l'ordre de plusieurs jours. Cette méthode de détermination n'est donc pas utilisable pour une estimation en temps réel.

On peut également envisager de mesurer les variations de charge de la batterie en intégrant dans le temps le courant circulant dans celle-ci en partant d'un point de départ connu et en connaissant la capacité maximum estimée de la batterie. On arrive alors à calculer l'état de charge de la batterie comme un pourcentage de la charge maximale. Toutefois, compte tenu des erreurs de mesure du courant, la valeur intégrée peut présenter des variations relativement importantes par rapport à la variation de charge réelle de la batterie.

A priori, aucune méthode de mesure directe de l'état de charge n'est possible durant les phases d'utilisation d'une batterie sans prévoir de capteur(s) supplémentaire(s) au niveau de la batterie (comme par exemple pour effectuer une mesure au niveau de la densité de l'acide se trouvant dans la batterie).

La présente invention a alors pour but de fournir un procédé permettant d'estimer l'état de charge d'une batterie dans un véhicule automobile. Ce procédé permettra de préférence une utilisation en temps réel et pourra être implémenté dans un calculateur de bord bon marché. Un autre but de l'invention est que cette estimation tienne compte des principaux phénomènes physiques se produisant à l'intérieur d'une batterie. Le procédé devra être suffisamment complexe pour fournir une indication fiable, mais pas trop complexe, pour faciliter son implémentation.

Un autre but de la présente invention est de simuler le comportement d'une batterie à court ou moyen terme pour permettre de prédire la capacité de la batterie à fournir une énergie suffisante pour une tâche donnée (par exemple démarrage à froid, arrêt et démarrage du moteur appelé aussi "stop & go",...).

À cet effet, la présente invention propose un procédé d'estimation de la charge d'une batterie d'un véhicule automobile dans lequel au moins un capteur fournit la tension aux bornes de la batterie, le courant circulant dans la batterie et la température de celle-ci.

Selon la présente invention, des variations de courant sont mesurées à des intervalles de temps prédéterminés afin de déterminer par intégration des variations de charge de la batterie,
- une tension modélisée est déterminée en fonction du courant et de la température à l'aide d'un modèle théorique,
- la tension modélisée comporte au moins une composante correspondant à la charge de la batterie et au moins une composante correspondant à la polarisation de la batterie,
- la tension estimée est comparée à la tension mesurée afin de déterminer une erreur de tension,
- une adaptation du modèle théorique est réalisée en fonction de la phase de fonctionnement de la batterie et en fonction de l'erreur de tension déterminée, et
- l'adaptation est réalisée pour le calcul théorique de l'état de charge de la batterie et/ou pour le calcul de la composante correspondant à la polarisation de la batterie,
- l'estimation de l'état de charge de la batterie étant déterminée à l'aide du modèle théorique adapté.

Un tel procédé permet ainsi de répondre au problème technique exposé plus haut en estimant l'état de charge d'une batterie en permanence. Grâce aux adaptations réalisées, le même procédé peut être utilisé sur plusieurs batteries et s'adapte aussi au vieillissement d'une batterie.

Dans un procédé d'estimation selon l'invention, les mesures de variation de courant sont réalisées à une fréquence supérieure à 1 Hz. On peut par exemple prévoir des mesures réalisées toutes les 10 ms ou toutes les 100 ms par exemple.

Les différents états de fonctionnement de la batterie considérés dans le procédé selon l'invention peuvent être choisis dans l'ensemble comportant le fonctionnement en circuit ouvert, le fonctionnement en charge et le fonctionnement en décharge.

On peut aussi de préférence prévoir qu'aux états de fonctionnement de la batterie en charge et en décharge correspondent à chaque fois des sous-états de fonctionnement choisis dans l'ensemble comportant le fonctionnement saturé à 100%, le fonctionnement saturé à près de 100%, le fonctionnement normal, le fonctionnement chargé à près de 0% et le fonctionnement chargé à 0%.

Pour ces divers sous-états, il est proposé que dans le sous-état de fonctionnement saturé à 100%, l'adaptation est réalisée sur l'état de charge de la batterie et sur la composante correspondant à la polarisation de la batterie, que dans le sous-état de fonctionnement saturé à près de 100%, l'adaptation est réalisée sur la composante correspondant à la polarisation de la batterie, que dans le sous-état de fonctionnement normal, l'adaptation est réalisée sur l'état de charge de la batterie et sur la composante correspondant à la polarisation de la batterie, que dans le sous-état de fonctionnement chargé à près de 0%, l'adaptation est réalisée sur la composante correspondant à la polarisation de la batterie, et que dans le sous-état de fonctionnement chargé à 0%, l'adaptation est réalisée sur l'état de charge de la batterie et sur la composante correspondant à la polarisation de la batterie.

On notera que la rapidité de l'adaptation de l'état de charge et la rapidité de l'adaptation de la polarisation dépendent (de manière indépendante l'une de l'autre) des états de fonctionnement de la batterie.

On peut également prévoir qu'à l'état de fonctionnement de la batterie en circuit ouvert correspondent des sous-états de fonctionnement choisis dans l'ensemble comportant le fonctionnement saturé à 100%, le fonctionnement saturé à près de 100%, le fonctionnement chargé à près de 0%, le fonctionnement chargé à 0%, le fonctionnement avec une tension stable, le fonctionnement avec une tension instable et le fonctionnement en circuit ouvert avec une stabilité longue.

Pour ces divers sous-états, il est proposé que dans les sous-états de fonctionnement saturé à 100%, de fonctionnement saturé à près de 100%, de fonctionnement chargé à près de 0% et de fonctionnement chargé à 0%, l'adaptation est réalisée sur l'état de charge de la batterie et sur la composante correspondant à la polarisation de la batterie, que dans l'état de fonctionnement avec une tension stable l'adaptation est réalisée sur l'état de charge de la batterie et sur la composante correspondant à la polarisation de la batterie avec une adaptation prépondérante sur l'état de charge, que dans l'état de fonctionnement avec une tension instable l'adaptation est réalisée sur l'état de charge de 1a batterie et sur la composante correspondant à la polarisation de la batterie avec une adaptation prépondérante sur la composante correspondant à la polarisation, et que dans l'état de fonctionnement en circuit ouvert avec une stabilité longue, l'adaptation est réalisée uniquement sur l'état de charge de la batterie.

Dans un procédé d'estimation selon l'invention, pour aider à déterminer les différents états de fonctionnement et les éventuels sous-états de fonctionnement, une minuterie peut être utilisée lorsque la batterie fonctionne en circuit ouvert pour mesurer le temps écoulé depuis l'ouverture du circuit.

La présente invention concerne également un programme d'ordinateur stocké sur un support d'informations, ledit programme comportant des instructions permettant la mise en oeuvre d'un procédé d'estimation tel que décrit plus haut, lorsque ce programme est chargé et exécuté par un système informatique.

Cette invention concerne enfin un système informatique tel par exemple un calculateur destiné à être embarqué à bord d'un véhicule automobile, caractérisé en ce qu'il comporte des moyens adaptés à mettre en oeuvre un procédé d'estimation tel que décrit ci-dessus.

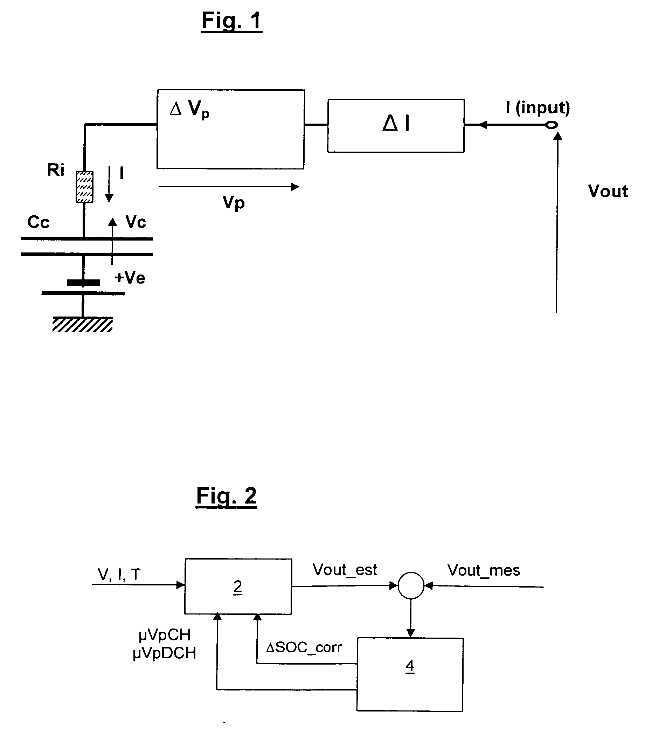

Des détails et avantages de la présente invention ressortiront mieux de la description qui suit, faite en référence au dessin schématique annexé, sur lequel :
- **La** **figure 1** est un schéma pour la modélisation d'une batterie utilisée dans la présente invention, et
- **La** **figure 2** illustre un procédé selon la présente invention.

On a représenté sur la figure 1 différents éléments pris en compte dans la présente invention pour réaliser une estimation de la charge d'une batterie. Cette batterie représentée sur la figure 1 comprend tout d'abord un élément aux bornes duquel règne une tension Ve. Cette dernière vaut généralement 11,5 V. Au-dessus de cet élément aux bornes duquel règne une différence de potentiel constante, se trouve sur la figure 1 une capacité appelée Cc qui permet "d'emmagasiner" l'énergie contenue dans la batterie. Lorsque cette capacité est entièrement chargée, la tension Vc à ses bornes vaut environ 1,3 V.

Les différents éléments constituant la batterie présentent une résistance regroupée ici en une seule résistance appelée Ri Selon la loi d'Ohm, une tension apparaît aux bornes de cette résistance lorsque celle-ci est traversée par un courant I.

De façon connue, lorsqu'une batterie est utilisée, une tension de polarisation, appelée ici Vp, apparaît. Cette tension est positive lorsque la batterie est en charge et négative lorsque la batterie se décharge. Cette tension de polarisation Vp résulte du courant circulant dans la batterie et de la température à laquelle celle-ci se trouve. Cette polarisation comporte à la fois une composante statique et une composante dynamique. La composante statique de la batterie est appelée Gp et on suppose que cette valeur dépend du courant 1 circulant dans la batterie, de la charge (SOC) et de la température T de la batterie, c'est à dire Gp (I, SOC, T).

La composante dynamique de la tension de polarisation correspond à un amortissement de premier ordre de cette tension dans le temps. Cet amortissement est réalisé avec une constante de temps τp. Cette constante de temps varie selon l'état de la batterie. Elle est ainsi inférieure lors d'une phase de décharge par rapport à une phase de charge. Cette constante de temps, en circuit ouvert, a une valeur supérieure par rapport à une phase en circuit fermé. De manière connue également, cette constante de temps est plus grande à froid qu'à chaud.

Ainsi, par exemple, ΔVp = Gp(I, SOC, T) / (1 + τp (I).S)

Enfin, il existe également dans une batterie une perte de courant symbolisée sur la figure 1 par Δl et désigné parfois sous le terme "gassing effect".

En régime permanent, lorsqu'aucun courant ne circule dans la batterie et que tous les effets de polarisation ont disparu (il faut parfois attendre plusieurs jours), la tension apparente Vout aux bornes de la batterie correspond à Ve + Vc.

En régime transitoire, en charge, en décharge ou en circuit ouvert, il convient de prendre en compte :
- le courant effectif, prenant en compte la perte de courant (gassing effect),
- la valeur de la tension Vc qui dépend de la charge de la capacité Cc,
- la perte de tension liée à la résistance interne Ri de la batterie,
- la tension de polarisation Vp liée au courant, au temps et à la température, et
- la tension aux bornes de la batterie étant la somme des tensions évoquée précédemment.

L'état de charge de la batterie est appelée SOC. Il correspond au ratio entre la charge actuelle de la batterie et sa charge maximale. On a ainsi:

SOC [%] = Q/Qmax.

Une manière habituelle de mesurer cet état de charge est de décharger entièrement la batterie jusqu'à ce que la tension aux bornes de la batterie chute afin de mesurer la charge restante Q (en Ah), puis de recharger entièrement la batterie et de la décharger entièrement à nouveau afin de déterminer la charge maximale Qmax. L'état de charge SOC est alors le ratio entre la charge Q et la charge Qmax mesurées.

Comme on peut le remarquer, ce test est long à réaliser, et il s'agit en outre d'un test intrusif qui modifie l'état initial de la batterie qui doit être mesuré.

On remarque en outre que la valeur Qmax mesurée dépend de la manière dont on décharge la batterie. Ceci ressort notamment de la loi de Peukert. Différents protocoles sont utilisés pour réaliser la décharge de la batterie. Celle-ci peut être effectuée par exemple en cinq heures (utilisé notamment comme standard au Japon), en vingt heures (utilisé généralement comme standard en Europe) ou bien en cent heures (pour les batteries de véhicules électriques). On supposera par exemple que la charge maximale Qmax utilisée ici par la suite correspond à la charge maximale mesurée lorsque la batterie est déchargée en vingt heures. Bien entendu, cette définition de Qmax n'influe pas sur la présente invention.

Pour la mise en oeuvre de l'invention, des capteurs mesurent au niveau de la batterie, le courant, la tension et la température.

À intervalles réguliers, des mesures sont réalisées et on calcule à partir de ces mesures des variations de courant et des variations de tension. Ces mesures sont, par exemple, réalisées toutes les 10ms ou 100ms.

Dans le procédé d'estimation de la charge de la batterie (SOC) selon la présente invention, on observe les paramètres (courant, tension, température) de la batterie et on voit comment celle-ci réagit. Parallèlement, un modèle estime, en fonction des paramètres et de leurs variations, comment la batterie devrait réagir. Ce modèle est adapté automatiquement en fonction des réactions de la batterie qui sont mesurées.

Le modèle utilisé pour la batterie est décrit plus haut. Par la suite, sont détaillés les calculs permettant d'estimer la tension aux bornes de la batterie afin de déterminer l'état de charge de celle-ci.

Tout d'abord, il convient de déterminer le courant efficace à prendre en compte. Ce courant correspond au courant total auquel on retire la perte de courant ΔI. Cette perte de courant est calculée à partir de la température et de la tension. La perte de courant peut être calculée par une formule ou bien être déterminée par consultation d'une table. Cette perte de courant est croissante avec la température et est également croissante avec la tension.

Pour le calcul de la tension Vc, deux modes de calculs peuvent être adoptés. On peut soit réaliser une intégration linéaire, soit réaliser une intégration non linéaire. Pour la réalisation d'une intégration linéaire, on part de l'équation suivante:

Vcₙ= Vcₙ₋₁-ΔA.h /Qmax [Ah] *

Vcmax

Dans cette équation, Vcₙ est la nouvelle valeur de la tension Vc à déterminer tandis que Vcₙ₋₁ est l'ancienne valeur déterminée de Vc.

Dans cette équation ΔA.h correspond à une variation de charge et est calculé en multipliant la valeur du courant (corrigé) par la durée de l'intervalle d'échantillonnage. On a alors :

SOC + Vc/Vcmax [%]

Avec Vcmax = 1,3 V habituellement.

Il est préféré toutefois de réaliser une intégration non linéaire. Ici, le nouvel état de charge est déterminé en fonction de l'ancien selon l'équation suivante :

SOCₙ =SOCₙ₋₁+-ΔA.h /Qmax [Ah] * 100 %

La tension Vc est alors déterminée à partir de l'état de charge SOC.

Pour le calcul de la tension aux bornes de Ri, on suppose que la valeur de cette résistance est connue et la tension est alors calculée en utilisant la loi d'Ohm.

Comme déjà indiqué plus haut, la tension de polarisation présente une composante statique et une composante dynamique. Le comportement de cette composante dynamique étant différent en charge ou en décharge de la batterie, il est proposé de couper le signal de tension Vp en deux signaux séparés, un signal positif intégrant les effets dus à la charge et un signal négatif reflétant les effets dus à la décharge. On obtient alors les équations suivantes :

Vp= Vp(Ch) + Vp(DCH)

| | | |
|---|---|---|
| avec | Vp(CH) = VPstat (CH) * Vp dyn (Ch) | >0 |
| et | Vp(DCH) = VP stat (DCH) * Vp dyn (DCH) | <0 |

où Vp(CH) correspond à la tension de polarisation en charge et Vp(DCH) correspond à la tension de polarisation lors d'une décharge.

Finalement, on obtient l'équation suivante pour la tension aux bornes de la batterie :

Vout = Ve + Vc + Ri * i + Vp

Cette tension, calculée comme indiqué précédemment, correspond à la tension modélisée représentant la réponse de la batterie à un courant donné. Comme toute modélisation, celle-ci présente des erreurs qu'il est nécessaire de corriger. Il est proposé ici de réaliser une adaptation du modèle.

Plusieurs adaptations peuvent être réalisées et combinées pour obtenir une correction globale correcte. L'adaptation est faite en fonction de la phase dans laquelle se trouve la batterie. On peut ainsi prévoir une adaptation lorsque la batterie est en circuit ouvert, une adaptation agissant sur le modèle de polarisation de la batterie et des adaptations lorsque l'état de charge de la batterie est proche de 0% ou de 100%.

Lorsque la batterie est en circuit ouvert, la tension à ses bornes Vout, tend assez précisément vers sa tension en circuit ouvert OCV.

L'estimation faite de l'état de charge SOC peut alors être corrigée pour devenir égal à la valeur correspondante de la tension en circuit ouvert OCV par une opération d'intégration en boucle fermée de l'erreur entre la valeur actuelle de l'état de charge et la valeur de l'état de charge équivalente à la tension en circuit ouvert OCV. Lorsque le régime permanent est atteint, les deux valeurs doivent être égales (et dépendent de la température). Les gains de cette opération dépendent de l'amortissement de la tension de polarisation et de la température : plus la polarisation est amortie, meilleurs sont les gains et plus la température est basse plus les gains sont bas. Le terme correctif pourra prendre la forme suivante : ΔSOC_corr = Kp*SOC_error + Ki* ∫ SOC_error.dt

Dans laquelle SOC_error = SOC_OCV-SOC_est

On obtient alors SOCₙ = SOCₙ₋₁ + ΔSOC_corr

Une minuterie est par exemple utilisée dès qu'une phase de charge ou de décharge de la batterie s'achève. On peut prévoir que cette minuterie se déclenche lorsque la valeur du courant passe sous un seuil prédéterminé, ce seuil étant bien entendu relativement bas. La correction de l'état de charge est alors réalisée lorsque la minuterie est enclenchée depuis un temps relativement important, par exemple plusieurs heures. On fait alors converger l'estimation de l'état de charge SOC vers la valeur SOC_OCV qui est l'état de charge correspondant à la tension en circuit ouvert de la batterie. Les gains Kp et Ki mentionnés dans l'équation précédente dépendent de la valeur de temps indiquée par la minuterie. On peut éventuellement prévoir Ki = 0.

Il est également possible de faire une extrapolation d'une part de la tension depuis que la batterie est en circuit ouvert et d'autre part de l'estimation de l'état de charge. Si l'extrapolation faite de l'état de charge ne correspond pas à la valeur de l'état de charge correspondant à la tension en circuit ouvert OCV extrapolée, une correction doit alors être réalisée.

Parallèlement aux adaptations réalisées en circuit ouvert, une adaptation concernant la polarisation peut être réalisée tant durant une phase de charge, que pendant une phase de décharge ou en circuit ouvert.

Le modèle de polarisation est représentatif des impédances non linéaires du circuit telles que décrites plus haut. Le comportement de cette polarisation peut largement varier d'une batterie à une autre et une auto-adaptation est donc ici nécessaire.

Pour réaliser cette adaptation concernant la polarisation d'une batterie, la tension de sortie mesurée est comparée en permanence à la tension de sortie calculée. On réalise en permanence une correction en fonction de la différence entre la tension mesurée et la tension calculée afin de compenser l'erreur sur la tension de polarisation et/ou la tension de charge (aux bornes de la capacité) ou la tension interne en circuit ouvert.

Lorsque l'état de charge SOC est supposé être le plus fiable, l'adaptation est réalisée en appliquant un terme correctif à la tension de polarisation. On utilise ici un facteur de correction µvp. Dans une forme de réalisation préférée, un facteur de correction µVpCH est utilisé après une charge de la batterie tandis qu'un facteur µVpDCH est appliqué après une phase de décharge.

Par contre, lorsque la tension de polarisation calculée est supposée être fiable, l'adaptation est réalisée sur l'estimation de l'état de charge SOC et on utilise alors le facteur correctif déjà évoqué plus haut, ΔSOC_corr.

La figure 2 illustre le procédé d'estimation selon l'invention mettant en oeuvre des adaptations tant sur l'état de charge que sur la tension de polarisation.

Sur la figure 2, la référence 2 représente la modélisation de la batterie tandis que la référence 4 représente les moyens d'auto-adaptation.

Comme il ressort de la description faite plus haut, des capteurs mesurent la tension V, le courant I et la température T de la batterie. Ces données sont injectées dans la modélisation de la batterie 2 afin de fournir une tension estimée Vout_est. Par ailleurs, cette tension Vout est mesurée et a la valeur Vout_mes. Les deux valeurs sont comparées et le résultat de cette comparaison est introduit dans les moyens d'auto-adaptation 4. Ceux-ci fournissent alors des termes correctifs ΔSOC_corr et µVpCH et µVpDCH.

La stratégie de combinaison de la correction de l'état de charge et de la tension de polarisation est gérée selon un schéma de principe prenant en compte le courant, la tension et la température ainsi que l'historique des corrections réalisées.

Un indicateur de confiance concernant la tension de polarisation peut être utilisé. Cet indicateur sera élevé après une longue phase en circuit ouvert ou après une longue phase durant laquelle le courant est sensiblement constant. Par contre, la confiance dans la tension de polarisation sera faible durant des phases de transition ou après une variation significative du courant.

Des adaptations sur la valeur de l'état de charge seront donc réalisées lorsque l'indicateur de confiance sur la valeur de polarisation est élevée.

D'autres adaptations peuvent également être réalisées. En effet, le système peut détecter automatiquement quelques situations typiques, notamment lorsque l'état de charge est proche de 0% ou proche de 100%. Lors d'une phase de décharge, lorsque l'état de charge atteint la limite de 0%, la tension de sortie décroît soudainement et très rapidement. Cette situation peut être facilement détectée en mesurant le gradient le tension.

Ainsi par exemple, si Vout décroît jusqu'à prendre une valeur inférieure à 10,5 V avec un gradient négatif sensible, ou si un courant de charge atteint une valeur très importante avec cependant une valeur Vout relativement faible, par exemple inférieure à 13,5 V, alors, l'estimation de l'état de charge SOC de la batterie est corrigée pour converger vers la limite inférieure de 0% correspondant à la température mesurée. Si l'état de charge est encore positif, alors l'état de charge estimé est réduit à 0%. Par contre, si l'état de charge estimé a déjà atteint 0% et tend à être négatif, alors l'état de charge est maintenu à 0%.

De manière similaire, il est possible de détecter un état de charge voisin de 100% durant une phase de charge de la batterie. La tension de sortie croît alors rapidement et soudainement, de telle sorte que l'état de charge voisin de 100% peut être facilement détecté en mesurant le gradient de tension.

Ainsi par exemple, si Vout augmente et dépasse 16,5 V, avec un gradient de tension important ou si le courant de charge atteint 0A avec une tension sensiblement stabilisée à une valeur relativement haute, par exemple supérieure à 14 V, alors l'estimation de l'état de charge SOC est corrigée pour converger vers la valeur de 100%. Si l'état de charge estimé est encore inférieur à 100%, alors cet état de charge est augmenté pour atteindre la valeur de 100%. Par contre, si l'état de charge estimé a déjà atteint 100% et tend à devenir supérieur à 100%, alors l'état de charge estimé est maintenu à 100%.

Le procédé décrit ci-dessus permet ainsi d'obtenir une bonne estimation de l'état de charge d'une batterie. Lors d'une première utilisation, par exemple après un changement de batterie, une période d'adaptation est le plus souvent nécessaire. Le procédé décrit ci-dessus, grâce notamment à l'adaptation de la tension de polarisation, permet d'obtenir assez rapidement une bonne estimation de l'état de charge.

Le procédé selon l'invention permet une estimation de la charge de la batterie durant toutes les phases d'utilisation de celle-ci. La valeur estimée est réajustée en permanence par comparaison entre une tension modélisée et une tension mesurée. Ceci permet d'avoir une estimation fiable de l'état de charge de la batterie tout au long de la vie de la batterie, même lorsque cette dernière vieillit.

Comme il ressort de la description ci-dessus, la présente invention est une application de plusieurs méthodes d'auto-adaptation, par prédiction ou par extrapolation, avec utilisation d'une correction temps réel en boucle fermée adaptée pour les phases de fonctionnement.

La présente invention ne se limite pas à la forme de réalisation décrite ci-dessus et aux variantes de réalisation évoquées. Elle concerne également toutes les variantes de réalisation à la portée de l'homme du métier dans le cadre des revendications ci-après.

## Revendications

1. Procédé d'estimation de la charge d'une batterie d'un véhicule automobile dans lequel au moins un capteur fournit la tension aux bornes de la batterie, le courant circulant dans la batterie et la température de celle-ci, tel:
• que des variations de courant sont mesurées à des intervalles de temps prédéterminés afin de déterminer par intégration des variations de charge de la batterie,
• qu'une tension modélisée est déterminée en fonction du courant et de la température à l'aide d'un modèle théorique,
• que la tension modélisée comporte au moins une composante correspondant à la charge de la batterie et au moins une composante correspondant à la polarisation de la batterie,
• que la tension estimée est comparée à la tension mesurée afin de déterminer une erreur de tension,
• qu'une adaptation du modèle théorique est réalisée en fonction de la phase de fonctionnement de la batterie comportant le fonctionnement en circuit ouvert, le fonctionnement en charge et le fonctionnement en décharge et en fonction de l'erreur de tension déterminée, le procédé étant **caractérisé en ce qu'**aux phases de fonctionnement de la batterie en charge et en décharge correspondent à chaque fois des sous-états de fonctionnement choisis dans l'ensemble comportant le fonctionnement saturé à 100%, le fonctionnement saturé à près de 100%, le fonctionnement normal, le fonctionnement chargé à près de 0% et le fonctionnement chargé à 0% et **en ce que** pour ces divers sous états, l'adaptation est réalisée pour le calcul théorique de l'état de charge de la batterie et/ou pour le calcul de la composante correspondant à la polarisation de la batterie, l'estimation de l'état de charge de la batterie étant déterminée à l'aide du modèle théorique adapté.

2. Procédé d'estimation selon la revendication 1, **caractérisé:**
• **en ce que** dans le sous-état de fonctionnement saturé à 100%, l'adaptation est réalisée sur l'état de charge de la batterie et sur la composante correspondant à la polarisation de la batterie,
• **en ce que** dans le sous-état de fonctionnement saturé à près de 100%, l'adaptation est réalisée sur la composante correspondant à la polarisation de la batterie,
• **en ce que** dans le sous-état de fonctionnement normal, l'adaptation est réalisée sur l'état de charge de la batterie et sur la composante correspondant à la polarisation de la batterie,
• **en ce que** dans le sous-état de fonctionnement chargé à près de 0%, l'adaptation est réalisée sur la composante correspondant à la polarisation de la batterie, et
• **en ce que** dans le sous-état de fonctionnement chargé à 0%, l'adaptation est réalisée sur l'état de charge de la batterie et sur la composante correspondant à la polarisation de la batterie.

3. Procédé d'estimation selon la revendication 1, **caractérisé en ce qu'**à l'état de fonctionnement de la batterie en circuit ouvert correspondent des sous-états de fonctionnement choisis dans l'ensemble comportant le fonctionnement saturé à 100%, le fonctionnement saturé à près de 100%, le fonctionnement chargé à près de 0%, le fonctionnement chargé à 0%, le fonctionnement avec une tension stable, le fonctionnement avec une tension instable et le fonctionnement en circuit ouvert avec une stabilité longue.

4. Procédé d'estimation selon la revendication 3, **caractérisé:**
• **en ce que** dans les sous-états de fonctionnement saturé à 100%, de fonctionnement saturé à près de 100%, de fonctionnement chargé à près de 0% et de fonctionnement chargé à 0%, l'adaptation est réalisée sur l'état de charge de la batterie et sur la composante correspondant à la polarisation de la batterie,
• **en ce que** dans l'état de fonctionnement avec une tension stable l'adaptation est réalisée sur l'état de charge de la batterie et sur la composante correspondant à la polarisation de la batterie avec une adaptation prépondérante sur l'état de charge,
• **en ce que** dans l'état de fonctionnement avec une tension instable l'adaptation est réalisée sur l'état de charge de la batterie et sur la composante correspondant à la polarisation de la batterie avec une adaptation prépondérante sur la composante correspondant à la polarisation, et
• **en ce que** dans l'état de fonctionnement en circuit ouvert avec une stabilité longue, l'adaptation est réalisée uniquement sur l'état de charge de la batterie.

5. Procédé d'estimation selon l'une des revendications 1 à 4, **caractérisé en ce qu'**une minuterie est utilisée lorsque la batterie fonctionne en circuit ouvert pour mesurer le temps écoulé depuis l'ouverture du circuit.

6. Programme d'ordinateur stocké sur un support d'informations, ledit programme comportant des instructions permettant la mise en oeuvre d'un procédé d'estimation selon l'une quelconque des revendications 1 à 5, lorsque ce programme est chargé et exécuté par un système informatique.

7. Système informatique tel par exemple un calculateur destiné à être embarqué à bord d'un véhicule automobile, **caractérisé en ce qu'**il comporte des moyens adaptés à mettre en oeuvre un procédé selon l'une quelconque des revendications 1 à 5.
